# EUROPEAN PATENT APPLICATION

(11) **EP 1 564 808 A1**
(43) Date of publication of application: **17.08.2005**
(21) Application number: 04021062.7
(22) Date of filing: 03.09.2004
(51) Int. Cl.: H01L 23/433

(54) **Electronic apparatus having liquid cooling system therein**

(30) Priority: 16.02.2004 JP 2004038134
(71) Applicant: Hitachi, Ltd., Chiyoda-ku, Tokyo 100-8010 (JP)
(72) Inventor: Naganawa, Takashi, Hitachi, Ltd., Chiyoda-ku Tokyo 100-8220 (JP); Minamitani, Rintaro, Hitachi, Ltd., Chiyoda-ku Tokyo 100-8220 (JP); Ohashi, Shigeo, Hitachi, Ltd., Chiyoda-ku Tokyo 100-8220 (JP); Nishihara, Atsuo, Hitachi, Ltd., Chiyoda-ku Tokyo 100-8220 (JP)
(74) Representative: Beetz & Partner Patentanwälte

(57) **Abstract**

For providing an electronic apparatus, having a cooling system therein, for enabling cooling operation of a CPU (200), which is mounted within a housing (100) of the apparatus and needs cooling thereof, the cooling system for cooling the CPU has a cooling jacket (50), a radiator (60), and a circulation pump (70), wherein conduits for conducting the liquid coolant into the cooling jacket are made from a metal-made tube, and the tubes are formed into spiral-like in the configuration, or bellows are formed on the way thereof, to be freely disposable within the housing, thereby causing no obstacle in the operations when assembling the apparatus and/or making maintenance thereon.

## Description

### BACKGROUND OF THE INVENTION

The present invention relates to an electronic apparatus, such as, a personal computer of being so-called a desktop type or a notebook type, and/or a server etc., for example, and in particular, having a liquid cooling system therein, thereby enabling to cool down a semiconductor integrated circuit (IC) element(s), i.e., a heat generating element that is mounted within an inside thereof, effectively, with an aid of a liquid coolant.

In general, cooling is necessary for the semiconductor IC element, which constitutes a heat generating body within an electronic apparatus, such as, a personal computer of so-called the desktop type or the notebook type, and/or a server etc., in particular, a CPU (Central Processing Unit), so as to ensuring the normal operation thereof. For that purpose, conventionally, it is common to achieve the cooling for it, with using a heat transfer material, with which fins are formed in one body, i.e. , so-called a heat sink, and also a fan for supplying a cooling air thereon. However, in recent years, small-sizing and high-integration of the semiconductor IC element, i.e., the heat generating element, results into localization of the heat generation, in particular, at a portion where the heat is generated within the heat generating element, and also for this reason, in the place of the conventional cooling system of such an air-cooling type, attention is paid on a cooling system of a liquid-cooling type, applying a coolant therein, such as, a water or the like, for example, and having a high efficiency in the cooling operation thereof.

Namely, in such the cooling system of applying the liquid-cooling type having high cooling efficiency therein, to be used in the personal computer of so-called the desktop type or the notebook type, and/or the server, etc. , as was already known in the following Patent Documents, etc. , in general, upon a surface of the CPU, as being the heat generating body, is directly mounted a member, such as, so-called a heat-receiving (or cooling) jacket, while conducting a liquid-like coolant to flow within a flowpassage formed within an inside of the heat-receiving jacket, so as to transfer the heat generation from the CPU into the coolant flowing within the jacket mentioned above, thereby achieving the cooling of the heat generating body at high efficiency. Further, in such the cooling system of the liquid-cooling type, it is common to make up a heat cycle, in which the cooling jacket functions as a heat receiving portion, and in more details thereof, it comprises a circulation pump for circulating the liquid coolant within a cycle, a heat radiating portion for radiating heat of the liquid coolant into an outside, i.e. , so-called a radiator, and further a coolant tank, which is provided in a part of the cycle, but depending upon the necessity thereof, and wherein those are connected through tubes made of metal and/or those made of an elastic material, such as, rubber or the like, for example.
Patent Document 1: Japanese Patent Laying-Open No. 2003-304086 (2003);
Patent Document 2: Japanese Patent Laying-Open No. 2003-022148 (2003);
Patent Document 3: Japanese Patent Laying-Open No. 2002-182797 (2002);
Patent Document 4: Japanese Patent Laying-Open No. 2002-189536 (2002); and
   Patent Document 5: Japanese Patent Laying-Open No. 2002-188876 (2002).

By the way, with such the cooling system relating to such the conventional art mentioned above, in a case where the passages for circulating the coolant within the cycle are made from such the tubes made of the elastic material, such as, rubber, etc., there occurs a phenomenon that the liquid coolant comes out from a wall surface of that tube through evaporation thereof; therefore, it is difficult to keep the coolant enclosed within the cycle for a long time period. Then, in the cooling system of the conventional art, commonly, a coolant tank is provided within the cycle, thereby filling up the liquid coolant, which comes out into an outside thereof.

However, in the case where the coolant tank is provided within the cycle for filling up the leakage of coolant into the outside, thus, it is further necessary to provide this coolant tank within a housing of such an apparatus; however, judging from strong demand made upon small-sizing of the apparatus in the recent years, it is difficult to keep a sufficient space within an inside of the housing of the apparatus, for providing the coolant tank therein. Further, this is remarkable, in particular, for the personal computer of the so-called the notebook type, which is strongly required to be, not only small in size, but also thin in thickness, in addition thereto, from a viewpoint of portability thereof. Also, providing the coolant tank within the housing cannot be said a preferable solution, necessarily, in particular, in the case where consideration is paid upon a possibility about leakage of the liquid coolant, which is stored within an inside of the tank into the outside thereof. Namely, if the cooling liquid comes out from the inside of the coolant tank, it will cause serious damages upon other parts, which are provided within an inside of the housing, in particular, the electronic parts.

On the other hand, with using a tube made of a metal, such as, copper or the like, in the place of the elastic material, such as, rubber, etc. , as was mentioned above, it is possible to protect the liquid coolant from the phenomenon mentioned above, i.e., leaking outside from the wall surface of the tube due to evaporation thereof. However, if the passages are made from such the tube made of a metal, such as, copper or the like, for example, for circulating the liquid coolant within the cycle, it can be considered that it brings about a difficulty in an assembling operation of installing the liquid cooling system into the housing of the apparatus, and/or in an operation of making maintenance thereupon. In particular, in the cooling system having such the structure as was mentioned in the above, when forming the pipes or conduits from the metal tubes for conducting coolant to flow into the cooling jacket, which is disposed upon the surface of the CPU, i.e., the heat generating element, thereby being as a member for transmitting the heat generation to the heat radiation portion, i.e., the radiator, it is difficult to move the position of the cooling jacket, freely, and for this reason, the operations come to be troublesome, in installation thereof when assembling or disassembling, as well as, installation thereof when making maintenance thereupon.

### BRIEF SUMMARY OF THE INVENTION

Then, according to the present invention, being accomplished by taking the problems in relation to the conventional arts mentioned above into the consideration, an object thereof is to provide the structure, wherein the conduits for the liquid coolant between the elements building up the cooling system, in particular, the conduits disposed around the cooling jacket is made up with using the metal tubes, so as to reduce the leakage of the liquid coolant therethrough, as well as, being movable freely, in the position thereof in the assembling operation of the cooling jacket, and thereby providing an electronic apparatus having the cooling system of liquid cooling type, being superior in the utility and high on the cooling efficiency thereof.

According to the present invention, for accomplishing the object as was mentioned above, there is provided an electronic apparatus which may comprise: a heat-generating semiconductor element being installed within an inside of a housing, said element necessitating cooling thereof for maintaining normal operation; and a liquid cooling system, being provided within said housing or in a part thereof, said liquid cooling system having: a cooling jacket being thermally connected with the semiconductor element for transmitting generated heat into a liquid coolant flowing within an inside thereof; a radiator for discharging the heat which is transmitted to said liquid coolant within said cooling jacket into an outside of said apparatus; and a circulation pump for circulating said liquid coolant within a loop including said cooling jacket and said radiator, wherein a conduit for conducting the liquid coolant to flow into said cooling jacket is made from a metal-made tube, and said tube is formed such that it enables said cooling jacket to be disposed at any position freely within said housing.

Further, according to the present invention, in the electronic apparatus, as described in the above, said conduits for conducting the liquid coolant to flow into said cooling jacket may be formed at least partially in a spiral-like configuration or a bellows is formed at least in a part thereof on way of said conduits for conducting the liquid coolant to flow into said cooling jacket, and further, said conduits for conducting the liquid coolant to flow into said cooling jacket may be attached to said cooling jacket along with a side thereof, so that said cooling jacket is rotatable therearound. Also, according to the present invention, it is preferable that said conduits for conducting the liquid coolant to flow into said cooling jacket are made from a copper tube.

However, the form of the tube is not restricted to a partially spiral-like and/or bellows-like form but may show any deviation from these forms which is suitable to enable a movement of the heat-receiving jacket by deformation of the metal-tube structure. For example, also a helical, wounded, staggered or zigzag form or any combination of different forms may be realized according to the invention.

### BRIEF DESCRIPTION OF THE SEVERAL VIEWS OF THE DRAWING

Those and other objects, features and advantages of the present invention will become more readily apparent from the following detailed description when taken in conjunction with the accompanying drawings wherein:
Figs. 1(a) and 1(b) are a perspective view for showing an example of the structure for attaching a heat-receiving jacket and a side view for showing the entire side-surface thereof, in an electronic apparatus, according to one embodiment of the present invention;
Fig. 2 is a partially exploded perspective view for showing the arrangement of respective parts within an inside of a personal computer of the desktop type, as being an electronic apparatus having the liquid cooling system therein, according to the embodiment of the present invention;
Fig. 3 is a perspective view for showing an example of the structure of the liquid cooling system mentioned above, in particular, of those around a CPU, i.e., the heat generation element;
Figs. 4(a) and 4(b) are a perspective view for showing an example of the structure for attaching the heat-receiving jacket and a side view for showing the entire side-surface thereof, in an electronic apparatus according to other embodiment of the present invention;
Figs. 5(a) and 5(b) are also a perspective view for showing an example of the structure for attaching the heat-receiving jacket and a side view for showing the entire side-surface thereof, in an electronic apparatus, but according to further other embodiment of the present invention;
Fig. 6 is a partially exploded perspective view for showing the entire structure, in particular, when applying the present invention into a personal computer of the notebook type;
Fig. 7 is a perspective view for showing an example of the structure for attaching the heat-receiving jacket in the liquid-cooling system shown in Fig. 6 mentioned above; and
Fig. 8 is an enlarged partial cross-section view for showing an example of the structure for attaching the heat-receiving jacket in the liquid-cooling system shown in Fig. 6 mentioned above.

### DETAILED DESCRIPTION OF THE INVENTION

Hereinafter, embodiments according to the present invention will be fully explained by referring to the attached drawings.

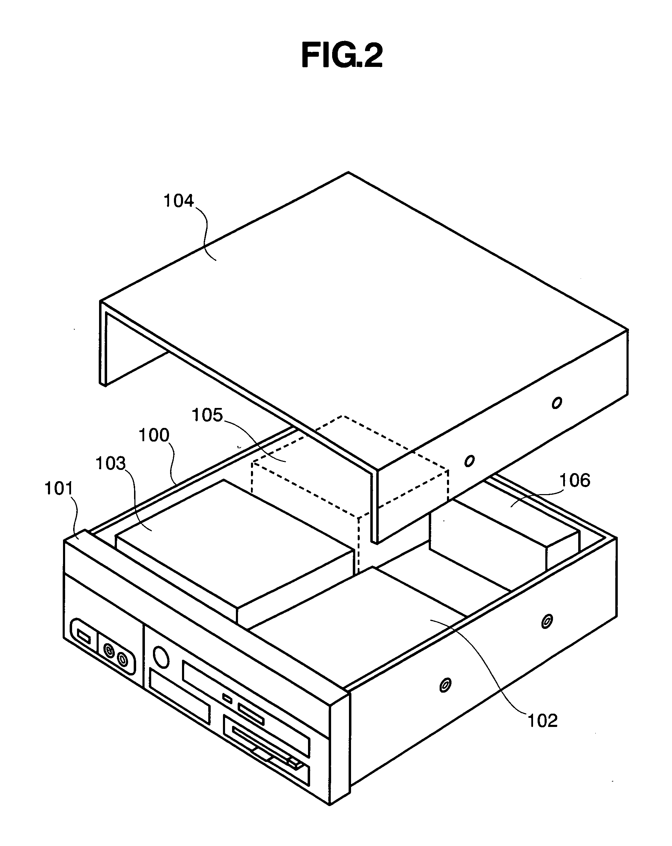

First of all, Fig. 2 attached herewith shows an example of the entire structure of an electronic apparatus having a liquid-cooling system therein, according to an embodiment of the present invention. However, in the present example, there is shown a case where the present invention is applied into a main body portion of , such as, a desktop-type personal computer, for example.

The main body portion of the desktop-type personal computer has, as shown in the figure, a housing 100, which is made from a metal plate forming into a cubic shape, for example, on a front panel portion 101 of which are provided various kinds of switches, including, such as, an electric power switch, connector terminals, and an indicator lamp, etc. , for example. Within an inside thereof is disposed a driver apparatus 102 for driving thereon various kinds of external information recording media, such as, a disk, a CD, a DVD, etc., in a such manner that an opening is made on the front panel portion 101. Also, a reference numeral 103 depicts a memory portion provided within an inside of the housing 100, made of a hard disk device, for example. And, a reference numeral 104 in the figure depicts a cover member to be put on the housing 100.

On the other hand, as is shown by broken lines, on a rear side surface of the housing 100 is provided a space for disposing therein an electronic circuit portion 105, having the liquid cooling system according to the present invention. Also, a reference numeral 106 in the figure depicts an electric power portion for supplying desired electric power sources from a commercial electric power source to the respective portions thereof, including the driver apparatus 102, the memory portion 103, and the electronic circuit portion 105.

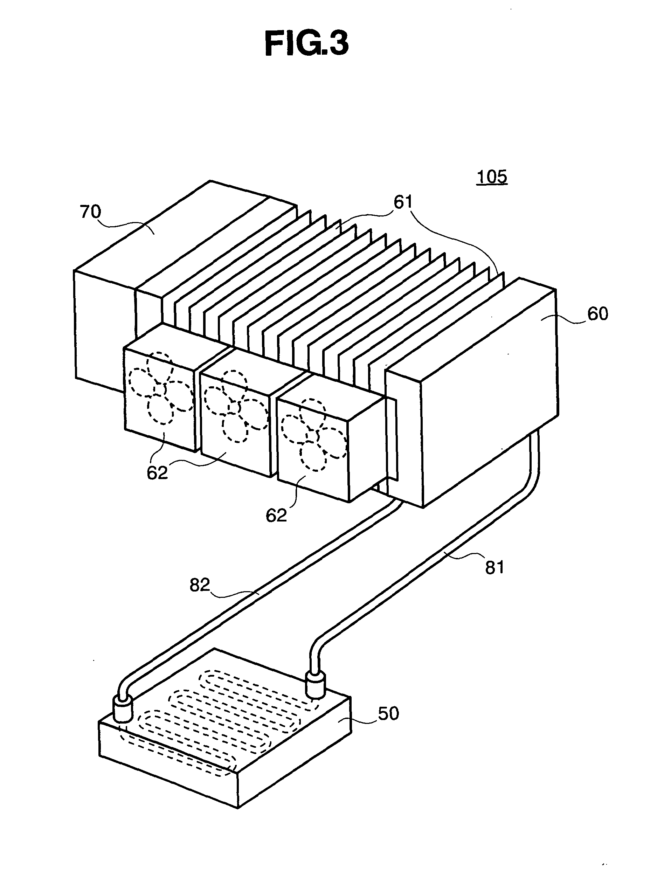

Next, Fig. 3 attached herewith shows the electronic apparatus, i.e., the electronic circuit portion 105 in the desktop-type personal computer, the detailed structure of which was explained in the above, and in particular, those around a heat-receiving jacket 50, which mounts thereon a heat-generating element, as being a main constituent part thereof. However, in the present example, a chip 200 of the CPU, i.e., the heat-generating element, is mounted onto a lower surface of the heat-receiving jacket 50 , being directly in contact with, and for this reason, it is not illustrated in the figure herein.

And, as is apparent from the Fig. 3 attached herewith, the electronic circuit portion 105 is connected with the heat-receiving (or cooling) jacket 50 mounting the CPU thereon, a radiator portion 60 for radiating the heat-generation from the CPU into an outside of the apparatus, a circulation pump 70 for building up a redundancy cooling system, and flow passages for conducting a liquid coolant (for example, a water, or a water mixed with an anti-freezing solution, such as, propylene glycol or the like, for example) to flow into the respective parts, building up the heat cycle with those mentioned above, by means of tubes (or conduits) 81 and 82, each of which is made from a metal, for example; i.e., it causes hardly the leakage of liquid coolant stored within an inside into an outside thereof. Also, in a part of the radiator portion 60 mentioned above, there are attached plate-type fans 62, 62... (in plural numbers thereof; such as, three (3), in this embodiment, for example) for blasting an air onto a large number of fins 61 formed to be the constituent elements thereof, thereby radiating the heat transmitted from the heat-receiving jacket 50, compulsively, directing into the outside of the apparatus. Further, this heat-receiving (or cooling) jacket 50 is that formed from aplate-likemember, being made of a metal having high heat transfer, such as, copper or the like, for example, and it is also formed with a cooling passage within an inside thereof, so as to conduct the liquid coolant to flow into the passage, thereby for removing (or moving) the heat-generation from the CPU into an outside thereof.

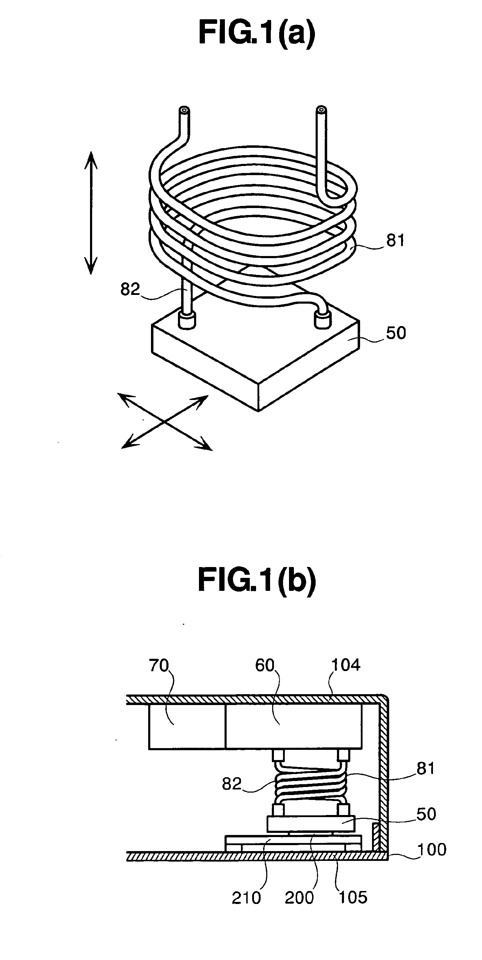

Following to the above, in Fig. 1(a) attached herewith are shown the heat-receiving jacket 50 and the tubes (i.e., the conduits) 81 and 82, made of a metal (such as, copper, for example), connected to the heat-receiving jacket, in more detailed configuration thereof. Thus, as is apparent from this figure, for taking in and out the liquid coolant to/from the heat-receiving jacket 50, a pair of metal-made tubes (or the conduits) 81 and 82, which are attached on the upper surface thereof, are disposed in parallel with each other and wound around in a spiral manner, in an upper portion thereof. Namely, the pair of the metal-made tubes (i.e., the conducts) 81 and 82 enables free movement of the heat-receiving jacket 50, which is attached at the tips thereof; i.e., in the vertical direction (up and down) and the horizontal direction (left-hand side and right-hand side), and also including the rotating direction therein, as is indicated by arrows shown in the figure, due to the function of the spiral-like portion formed on the middle portion thereof.

In more details thereof, as is shown in Fig. 1(b) attached, in the present embodiment, the radiator portion 60 and the circulation pump 70 for driving the liquid coolant circularly are attached with using a portion of the housing 100 of the apparatus, and the pair of the metal-made tubes (i.e., the conduits) 81 and 82 mentioned above are extended from that radiator portion 60 into a lower portion, and as is illustrated in the figure, while being wound around in the spiral manner, they reach to the heat-receiving jacket 50. On the other hand, the heat-generating element that needs cooling for keeping the normal operation thereof, i.e., the CPU 200 is mounted on a printed circuit board, which is disposed on a bottom plate 105 of the housing 100 mentioned above, and it is in contact with a lower surface of the heat-receiving jacket 50, under the condition shown in the figure. However, not shown in the figure, in an assembling operation, the heat-receiving jacket 50 is attached to be in contact with a surface of the CPU 200, under the condition of detaching or removing the cover 104 from the housing 100, in normal, (not shown in the figure, but it is mounted on and fixed thereto through screws, etc. , for example), and thereafter, the cover 104 is put on the housing 100 at a predetermined position, to be fastened thereto. In that instance, as was mentioned in the above, the heat-receiving jacket 50 is connected with the pair of the metal-made tubes (i.e., the conduits) 81 and 82, extending from the radiator portion 60, which is fixed in a portion of the cover 104, however since they are formed in spiral-like shape in the middle portion thereof, therefore the heat-receiving jacket can move or shift the position thereof, freely, so as to make the assembling operation thereof easy.

Also, in the similar manner, in a case of making maintenance thereon, also under the condition of taking out the cover 104 from the housing 100, the heat-receiving jacket 50 is removed, from the condition of being in contact with the surface of the CPU 200, in normal (not shown in the figure, but for example, after removing the screws for fixing, the heat-receiving jacket 50 is moved, vertically or horizontally). In that instance, too, as was mentioned in the above, although the heat-receiving jacket 50 is connected with the pair of the metal-made tubes (i.e., the conduits) 81 and 82, extending from the radiator portion 60, which is fixed in a portion of the cover 104, however since they are formed in the spiral-like shape in the middle portion thereof, therefore the heat-receiving jacket can move or shift in the position thereof, freely, so as to make the assembling operation easy. Further, it is the same to the above, that the cover 104 is put on the housing 100 at the predetermined position to be fixed thereon, again, after completing the maintenance thereon.

In this manner, with the electronic apparatus having such the liquid cooling system as was mentioned above, the conduits in the periphery of the heat-receiving jacket 50 are made up with using the metal-made tubes (i.e., the conduits) 81 and 82, in the place the tubes, being made of the elastic material, normally, such as, rubber or the like, which were used in the conventional arts, for keeping mobility thereof, by taking the assembling operation into the consideration; therefore, it is possible to reduce the leakage of the liquid coolant into an outside, which flows inside the said conduit portions. For example, with this, it is possible to obtain an apparatus that enables the operation thereof for a predetermined long time period (such as, for a term of guarantee of the apparatus, etc., for example) without filling-up (or refilling) of the liquid coolant, but with no provision of the coolant tank therein, and thereby achieving small-sizing of the apparatus as a whole, as well. Also, in addition thereto, since the heat-receiving jacket can be moved, freely, in the position thereof, for example, when assembling or making the maintenance thereon, it does not come to be an obstacle in the operations thereof.

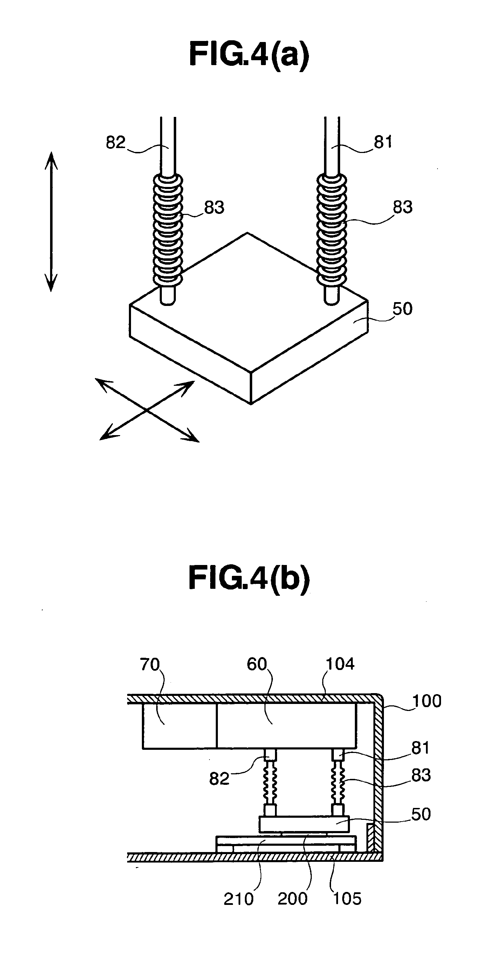

Next, Figs. 4(a) and 4(b) attached herewith show the heat-receiving jacket 50, and the tubes (i.e., the conduits) 81 and 82 made of metal, which are connected to the heat-receiving jacket 50, but in the liquid cooling system, according to other embodiment of the present invention. Namely, in this embodiment, as is apparent from Fig. 4(a), for taking in/out the liquid coolant to/from the heat-receiving jacket 50, a pair of the metal-made tubes (i.e., the conduits) 81 and 82, which are attached on an upper surface thereof, they are so made up to have so-called metal-made bellows 83 and 83 on the ways thereof, respectively. Also in Fig. 4(b) is shown the heat-receiving jacket 50, which is connected with the radiator portion 60 through the pair of the metal-made tubes (i.e., the conduits) 81 and 82, having the bellows 83 and 83 mentioned above, under the condition where it is attached upon the CPU 200, i.e., the heat-generating element, which is mounted on the printed circuit board 210 disposed on the bottom plate 105 of the housing 100, being in contact with the surface thereof. Further, also in this embodiment, with such the pair of metal-made tubes (i.e., the conducts) 81 and 82, due to the functions of the bellows 83 and 83 thereof, respectively, it is possible to keep the heat-receiving jacket 50 that is attached at the tips thereof, being movable, freely, and therefore, in the similar manner as was mentioned above, it will not come to be an obstacle in the operations, for example, when assembling or making the maintenance thereon. Further, there is no necessity of providing the coolant tank in a part thereof, and therefore, it is possible to achieve small-sizing of the apparatus, and also to enable the apparatus to operate for a predetermined long time period (such as, the term of guarantee of the apparatus, etc., for example), but without filling-up (refilling) of the liquid coolant.

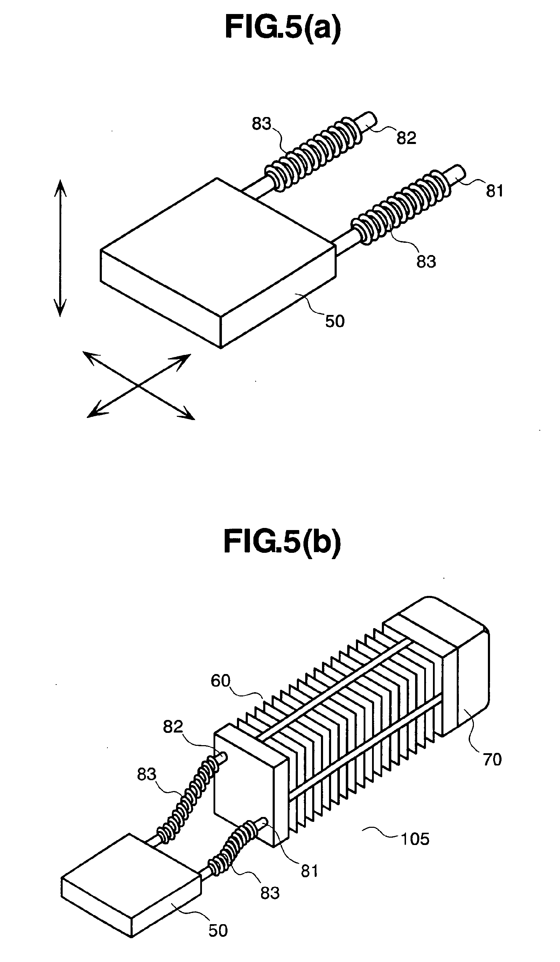

Furthermore, Figs. 5(a) and 5(b) attached herewith show the heat-receiving jacket 50 and the metal-made tubes (i.e., the conduits) 81 and 82, but in the liquid cooling system according to further other embodiment. In more details, the metal-made bellows 83 and 83, which are also shown in Fig. 4(a), are attached onto a sidewall portion of the heat-receiving jacket 50. However, such the structure is advantageous, in particular, in a case where the radiator portion 60 is fixed onto a side of the bottom plate 105 of the housing 100, as apparent from Fig. 5(b). In this manner, also with such the other embodiment, since it is possible for the pair of the metal-made tubes (i.e., the conduits) 81 and 82 to keep the heat-receiving jacket 50 that is attached at the tips thereof, being movable freely, due to the functions of the bellows 83 and 83 thereof, respectively, and therefore, in the similar manner as was mentioned above, it will not come to be an obstacle in the operations, for example, when assembling or making the maintenance thereon. And further, there is no necessity of providing the coolant tank in a part thereof, therefore, it is possible to achieve small-sizing of the apparatus, and also to enable the apparatus to operate for a predetermined long time period (such as, the term of guarantee of the apparatus, etc. , for example), but without filling-up (refilling) of the liquid coolant.

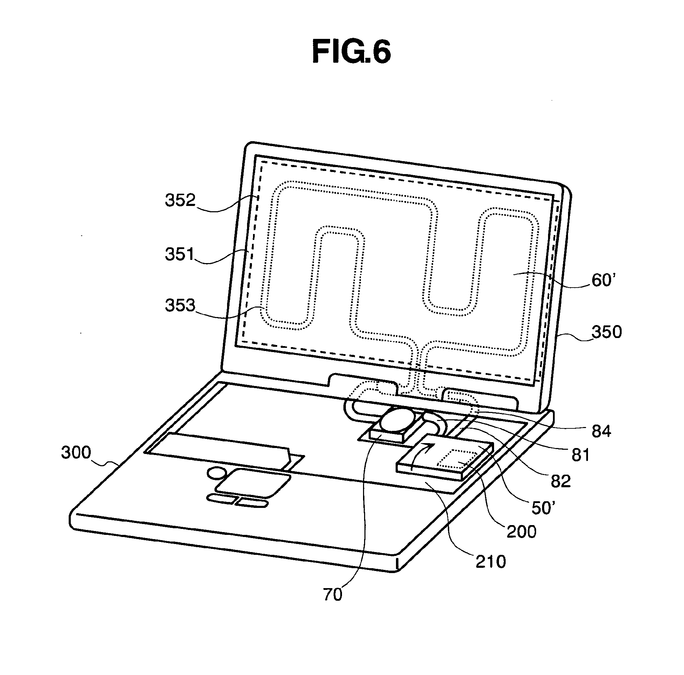

Next, Figs. 6 to 8 attached herewith show an example of the entire structure of the electronic apparatus, having the liquid cooling system therein, according to further other embodiment of the present invention. Namely, in the present example is shown a case where the liquid cooling system mentioned above is applied, in particular, into a main body portion of the notebook-type personal computer, for example.

First of all, Fig. 6 shows the structure of the personal computer, being of so-called the notebook-type, in general, and it is constructed with a main body or portion 300 of the personal computer, as well as, a cover body or portion 350 , which is attached onto the main body 300 through a hinge mechanism, in such a manner that it can be freely opened and/or closed thereto. In this figure, however, the main body 300 is shown under the condition that the keyboard portion thereof is removed therefrom, for the purpose of showing an inside thereof, although it is normally attached on that surface thereof. With such the notebook-type personal computer, being small in the sizes and portable, differing from such the desktop-type personal computer mentioned above , normally, a metal plate 352 is positioned on a reverse side of a liquid crystal display 351, which is attached on an interior side surface of the cover portion 350, and also a radiator portion 60'is formed from ametal-made conduit 353 , being wound around on the surface thereof. However, it is same to the above, that the heat-receiving (cooling) jacket 50 and the circulation pump 70, including the radiator portion 60' therein, build up the heat cycle, thereby forming a cooling system, and that the flow passages are formed, so as to conduct the liquid coolant (for example, a water, or a water mixed with so-called an anti-freezing solution, such as, proplylene glycol or the like, at a predetermined ratio, etc.) to flow through each of the portions, which build up that heat cycle. However, in this figure, arrows indicate the directions, into which the heat-receiving (cooling) jacket 50 is movable.

Also, in this example shown in Fig. 6, upon the printed circuit board 210 disposed on the bottom portion of the main body 300 is mounted the CPU 200, as being the heat-generating element, and upon the upper surface thereof is attached the heat-receiving jacket 50', also in the similar manner to that mentioned above, i.e., under the condition of being in contact with each other on the surfaces thereof (not shown in the figure, but being fixed with by means of, such as, screws, etc., for example). And, as the flow passages formed between those portions, which build up the heat cycle, there are connected tubes (i.e., conduits) 80, which are also formed from a metal, in the similar manner to that mentioned above, so that the liquid coolant within the inside thereof cannot come out into an outside, easily. However, a reference numeral 84 in the figure depicts a hinge pipe provided for connecting between the main body 300 and the cover body 350.

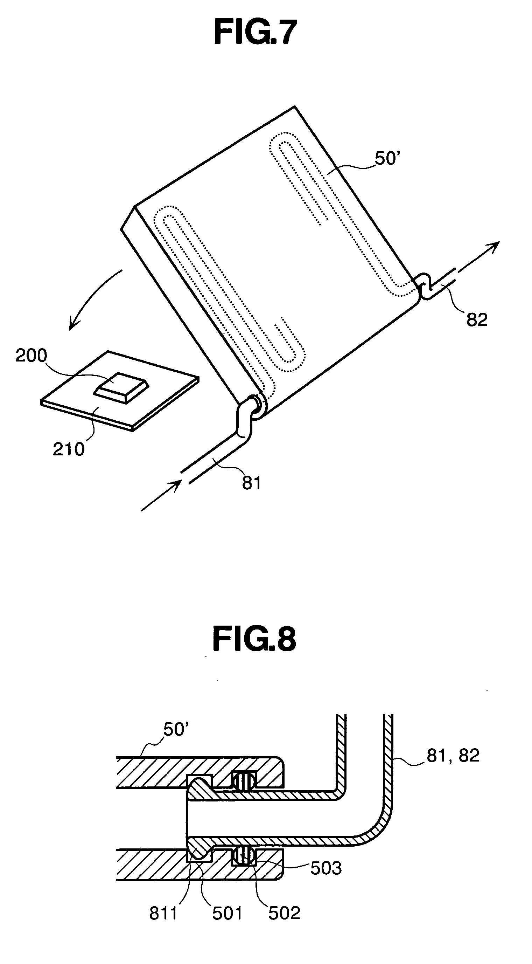

And, as is shown in Fig. 7 attached herewith, the heat-receiving jacket 50' is formed into be plate-like in the outer configuration thereof, within an inside of which are formed the flowpassages for the liquid coolant (see broken lines in the figure), and it is attached along a side thereof, being rotatable around it. In more details, at a position in the vicinity of the printed circuit board 210, on which the CPU 200 is mounted (or, on the printed circuit board 210), the tubes (i.e., the conduits) 81 and 82 are fixed, and between those tubes (i.e., the conduits) 81 and 82 is attached the heat-receiving jacket 50', being rotatable. Further, an example of the connecting structure therebetrween is shown in Fig. 8 attached herewith, which also seals up liquid-tightly between the tubes (i.e., the conduits) 81 and 82 and the heat-receiving jacket 50'.

Namely, as is apparent from this Fig. 8 mentioned above, a projection or convex portion 811 formed at a tip portion of the tube (i.e., the conduit) 81 or 82 is inserted into a recess or concave portion 501, which is formed on the periphery of the flow passage defined within the heat-receiving jacket 50', to be connected with, and then the heat-receiving jacket 50' is attached therewith, so that it can be rotated with respect to the tubes (i.e., the conduits) 81 and 82. Further, a reference numeral 502 in the figure is a so-called a "O"-ring, which is also inserted into the recess portion 503 formed in the portion of the passage of the heat-receiving jacket 50', for maintaining the sealing capacity of the liquid coolant upon the connecting portion mentioned above.

In this manner, also in the personal computer of the notebook-type, i.e., the electronic apparatus having the liquid cooling system therein, according to the further other embodiment shown in Figs. 6 to 8 mentioned above, the heat-receiving jacket 50' can keep the movement thereof, freely, in particular, in the rotating directions thereof; therefore, in the similar manner to that mentioned above, it will not come to be an obstacle in the operations, for example, when assembling or making the maintenance thereon. And further, there is no necessity of providing the coolant tank in a part thereof, therefore, it enables to achieve small-sizing of the apparatus, and also enables the apparatus to operate for a predetermined long time period (such as, the term of guarantee of the apparatus, etc., for example), but without filling-up (refilling) of the liquid coolant. Furthermore, in particular, such the structure as was mentioned above, i.e., having no necessity of providing the coolant tank therein, comes to be a very advantageous characteristic for the personal computer of the notebook-type, in particular, upon which the portability and/or the small-sizing are strongly demanded.

Namely, in accordance with the present invention mentioned above, there can be achieved an affect of obtaining an electronic apparatus having a cooling system therein, which will not come to be an obstacle in the operations, in particular, when assembling the apparatus or making the maintenance thereof, but without provision of the coolant tank therein, thereby enabling of small-sizing of the apparatus, and enabling the apparatus to operate for the predetermined long time period, without necessity of filling-up (refilling) of the liquid coolant.

The present invention may be embodied in other specific forms without departing from the spirit or essential feature or characteristics thereof. The present embodiment(s) is/are therefore to be considered in all respects as illustrative and not restrictive, the scope of the invention being indicated by the appended claims rather than by the forgoing description and range of equivalency of the claims are therefore to be embraces therein.

## Claims

1. An electronic apparatus, comprising:
a heat-generating semiconductor element (200), being installed within an inside of a housing (100) thereof, which element necessitates cooling thereof for maintaining normal operation thereof; and
a liquid cooling system, being provided within said housing (100) or in a part thereof, and having:
a cooling jacket (50), being thermally connected with the semiconductor element (200), for transmitting heat-generation thereof into a liquid coolant flowing within an inside thereof;
a radiator (60) for discharging the heat, which is transmitted to said liquid coolant within said cooling jacket (50), into an outside of said apparatus; and
a circulation pump (70) for circulating said liquid coolant within a loop, including therein said cooling jacket (50) and said radiator (60), wherein
conduits (81, 82) for conducting the liquid coolant to flow into said cooling jacket (50) are made from a metal-made tube, and further said tube enables is such that it enables said cooling jacket (50) to be disposed at position thereof, freely within said housing (100).

2. Electronic apparatus according to claim 1, **characterized in that** said conduits (81, 82) for conducting the liquid coolant to flow into said cooling jacket (50) are formed in at least partially a spiral-like configuration.

3. Electronic apparatus according to claim 1 or 2, **characterized in that** a bellows (83) is formed at least in a part on way of said conduits (81, 82) for conducting the liquid coolant to flow into said cooling jacket (50).

4. Electronic apparatus according to at least one of claims 1-3, **characterized in that** said conduits (81, 82) for conducting the liquid coolant to flow into said cooling jacket (50) are attached to said cooling jacket (50) along with a side thereof, so that said cooling jacket (50) is rotatable therearound.

5. Electronic apparatus according to at least one of claims 1-4, **characterized in that** said conduits (81, 82) for conducting the liquid coolant to flow into said cooling jacket (50) are made from a copper tube.

6. A liquid cooling system for an electronic apparatus, comprising:
a cooling jacket (50), being thermally connected with a semiconductor element (200) installed within the electronic apparatus, for transmitting heat-generation thereof into a liquid coolant flowing within an inside thereof;
a radiator (60) for discharging the heat, which is transmitted to said liquid coolant within said cooling jacket, into an outside of said apparatus; and
a circulation pump (70) for circulating said liquid coolant within a loop, including therein said cooling jacket and said radiator, wherein
conduits (81, 82) for conducting the liquid coolant to flow into said cooling jacket (50) are made from a metal-made tube, and further said tube enables is such that it enables said cooling jacket to be disposed at position thereof, freely within said housing.

7. Liquid cooling system according to claim 6, **characterized in that** said conduits (81, 82) for conducting the liquid coolant to flow into said cooling jacket are formed in spiral-like in configuration thereof.

8. Liquid cooling system according to claim 6 or 7, **characterized in that** a bellows (83) is formed on way of said conduits (81, 82) for conducting the liquid coolant to flow into said cooling jacket (50).

9. Liquid cooling system according to at least one of claims 6-8, **characterized in that** said conduits (81, 82) for conducting the liquid coolant to flow into said cooling jacket (50) are attached to said cooling jacket (50) along with a side thereof, so that said cooling jacket (50) is rotatable therearound.

10. Liquid cooling system according to at least one of claims 6-9, **characterized in that** said conduits (81, 82) for conducting the liquid coolant to flow into said cooling jacket (50) are made from a copper tube.
